# EUROPEAN PATENT APPLICATION

(11) **EP 1 921 689 A1**
(43) Date of publication of application: **14.05.2008**
(21) Application number: 07113663.4
(22) Date of filing: 02.08.2007
(51) Int. Cl.: H01L 51/52

(54) **Organic light-emitting display device and fabricating method of the same**

(30) Priority: 10.11.2006 KR 20060111074
(71) Applicant: Samsung SDI Co., Ltd., Suwon-si Gyeonggi-do (KR)
(72) Inventor: Choi, Dong-soo, Gyeonggi-do (KR); Joo, Young-cheol, Gyeonggi-do (KR); Park, Jin-woo, Gyeonggi-do (KR)
(74) Representative: Hengelhaupt, Jürgen

(57) **Abstract**

Disclosed is an organic light emitting display device and a fabricating method of the same. More particularly, the present invention relates to an organic light emitting display device capable of uniformly sealing an inorganic sealing agent, and a fabricating method of the same. The organic light emitting display device according to the present invention includes a first substrate including a pixel array having at least one organic light emitting diode formed therein; a second substrate coalesced to the first substrate; and an inorganic sealing agent (150) surrounding the pixel array and having at least a straight-line portion (A) and a corner portion (A'), wherein the straight-line portion (A) and the corner portion (A') of the inorganic sealing agent (150) have the same effective sealing width (W).

## Description

### BACKGROUND

### 1. Field

The present invention relates to an organic light emitting display device and a fabricating method of the same, and more particularly to an organic light emitting display device capable of uniformly sealing an inorganic sealing agent, and a fabricating method of the same.

### 2. Discussion of Related Art

In recent years, organic light emitting display devices using an organic light emitting diode have attracted public attention.

The organic light emitting display device, which is an emissive display that emits the light by electrically exciting an organic compound having flourescence characteristics, may be driven at a low voltage and easily reduced in its thickness, and has a wide optical viewing angle, a rapid response time, etc.

The organic light emitting display device includes an organic light emitting diode formed on a substrate; and a plurality of pixels including TFT (a thin film transistor) for driving the organic light emitting diode. Such an organic light emitting diode is sensitive to moisture. Accordingly, there has been proposed a method for preventing penetration of moisture using a metal cap or an encapsulation glass substrate coated with a humectant. However, the organic light emitting display device has out gas generated in the humectant with which the encapsulation substrate is coated which is weak to moisture or oxygen. Therefore, display characteristics are deteriorated due to damage to an organic EL emissive material or anode material and dim spots may occur.

For this purpose, U.S. Patent No. 6,998,776 discloses a structure in which an organic light emitting diode is sealed by coating a glass substrate with an inorganic sealing agent (frit). As disclosed in U.S. Patent No. 6,998,776 the organic light emitting diode may be protected in a more effective manner by sealing a space between the substrate and the encapsulation substrate using the inorganic sealing agent.

Meanwhile, the substrate and the encapsulation substrate are generally attached to each other by applying heat, for example a laser, etc., to the inorganic sealing agent in the structure in which an organic light emitting diode is sealed using an encapsulation substrate coated with an inorganic sealing agent. A sealing quality of the inorganic sealing agent depends on capacity of the irradiated laser.

### SUMMARY OF THE INVENTION

Accordingly, the present invention is designed to solve such drawbacks of the prior art, and therefore an object of the present invention is to provide an organic light emitting display device the entire region of which an inorganic sealing agent is homogeneously formed, and a fabricating method of the same.

One aspect of the present invention is achieved by providing an organic light emitting display device including a first substrate including a pixel array having at least one organic light emitting diode formed therein; a second substrate coalesced to the first substrate; and an inorganic sealing agent surrounding the pixel array and having at least a straight-line portion and a corner portion, wherein the straight-line portion and the corner portion of the inorganic sealing agent have the same effective sealing width.

Another aspect of the present invention is achieved by providing a method for fabricating an organic light emitting display device comprising a first substrate including a pixel array having at least one organic light emitting diode formed therein; a second substrate coalesced to the first substrate; and an inorganic sealing agent surrounding the pixel array and having at least a straight-line portion and a corner portion, the method including steps of applying the inorganic sealing agent around the pixel array of the second substrate; sintering the inorganic sealing agent at a predetermined temperature; coalescing the first substrate to the second substrate; and attaching the first substrate to the second substrate by irradiating the inorganic sealing agent with a laser, wherein the corner portion is irradiated with the laser having a lower intensity than that with which the straight-line portion is irradiated.

Still another aspect of the present invention is achieved by providing a method for fabricating an organic light emitting display device comprising a first substrate including a pixel array having at least one organic light emitting diode formed therein; a second substrate coalesced to the first substrate; and an inorganic sealing agent surrounding the pixel array and having at least a straight-line portion and a corner portion, the method including steps of applying the inorganic sealing agent around the pixel array of the second substrate; sintering the inorganic sealing agent at a predetermined temperature; coalescing the first substrate to the second substrate; and attaching the first substrate to the second substrate by irradiating the inorganic sealing agent with a laser, wherein the corner portion is irradiated with the laser at a more rapid rate than that at which the straight-line portion is irradiated.

An organic light emitting display device comprises a first substrate, a second substrate, an array of organic light emitting pixels, and a frit seal.

The array of organic light emitting pixels is interposed between the first substrate and the second substrate.

The frit seal interconnects the first substrate and the second substrate. The frit seal comprises a plurality of straight-line portions and a plurality of corner portions, and each of the portions comprises sealing surfaces to each of the first and second substrates.

The straight-line portions and the corner portions have substantially identical widths of the sealing surfaces to each of the first and second substrates, and the frit seal is substantially homogeneous in width and microstructure in the straight-line portion and the corner portion.

The corner portion may be a rounded corner portion. The radius of osculating circle of the rounded corner portion may be from about 0.5mm to about 1.5mm.

The corner portion may comprise a substantially rectangular corner portion. The ratio of the width of the sealing surfaces of the straight-line portion to the width of the sealing surfaces of the corner portion may be from about 0.85 to about 1.0.

The width of the sealing surfaces may be from about 0.3mm to about 1.0mm.

The thickness of the frit seal in the straight-line portions may be substantially identical to the thickness of the frit seal in the corner portions. The thickness of the frit seal may be from 5 m to about 30 m.

The microstructure of the frit seal may comprise a plurality of air bubbles trapped in the frit seal. The straight-line portions and the corner portions may contain the air bubbles of a substantially identical concentration.

A method of fabricating the above organic light emitting display device comprises: applying a frit material around said array of organic light emitting pixels and interposed between the first and second substrates; and irradiating the frit material with a laser, whereby the frit seal having an identical width is formed to form the sealing surfaces to the first substrate the second substrate.

The step of irradiating may be configured for the straight-line portions and the corner portions of the frit seal to receive substantially identical amount of energy from the laser.

The step of irradiating may comprise: sweeping the laser with a constant speed; and controlling intensity of the laser according to location that is irradiated by the laser. The corner portion of the frit seal may be irradiated by the laser with a reduced intensity.

The straight-line portion may comprise a distant sub-portion located distantly from the corner portion and a near sub-portion located closer to the corner portion, and the near sub-portion is irradiated by the laser with lower intensity than the distant sub-portion.

The step of irradiating may comprise: maintaining intensity of the laser at a substantially constant value; and controlling sweeping speed of the laser according to location that is irradiated by the laser. The corner portion of the frit seal may be irradiated by the laser with a heightened sweeping speed.

The straight-line portion may comprise a distant sub-portion located distantly from the corner portion and a near sub-portion located closer to the corner portion, and wherein the near sub-portion is irradiated by the laser with a higher sweeping speed than the distant sub-portion.

The step of applying a frit material may comprise: applying the frit material on the second substrate around the array of organic light emitting pixels; sintering the frit material at a predetermined temperature; and coalescing the first substrate to the second substrate.

The predetermined temperature may be from about 300 degrees to about 700 degrees in Celsius. The method may further comprise masking the array of organic light emitting pixels such that the array of organic light emitting pixels is not damaged by the laser.

The frit seal may comprise a filler that controls a thermal expansion coefficient of the frit seal. The frit seal may comprise an absorbing agent that facilitates the frit seal to absorb the laser.

The step of irradiating may be configured for the straight-line portions and the corner portions of the frit seal to receive substantially identical amount of energy from the laser, and the corner portion is a circular corner portion.

### BRIEF DESCRIPTION OF THE DRAWINGS

These and/or other aspects and advantages of the invention will become apparent and more readily appreciated from the following description of embodiments, taken in conjunction with the accompanying drawings of which:
FIG. 1 is a plane schematic view showing an organic light emitting display device according to an embodiment of the present invention.
FIG. 2 is an exploded view showing one region of FIG. 1.
FIG. 3 is a perspective view showing the organic light emitting display device according to another embodiment of the present invention and a laser irradiation equipment for fabricating the same.
FIG. 4a to FIG. 4d are a perspective view showing a method for fabricating the organic light emitting display device according to still another embodiment of the present invention. **[0037]** FIG. 5 is a schematic exploded view of a passive matrix type organic light emitting display device in accordance with one embodiment.
FIG. 6 is a schematic exploded view of an active matrix type organic light emitting display device in accordance with on embodiment.
FIG. 7 is a schematic top plan view of an organic light emtting display in accordance with one embodiment.
FIG. 8 is a cross-sectional view of the organic light emitting display of FIG. 7, taken along the line d-d.
FIG. 9 is a schematic perspective view illustrating mass production of organic light emitting devices in accordance with one embodiment.

### DETAILED DESCRIPTION OF EMBODIMENTS

The invention relates to sealing an OLED display device between two substrates. The device has first and second substrates. An array of organic light emitting pixels is formed on the first substrate. A frit seal is applied around the array of organic light emitting pixels and is irradiated with a laser. The amount of laser beam irradiated on the frit seal is important in determining the quality of the frit seal. If the laser irradiates a portion of the frit seal too much, then many air bubbles in the frit seal are formed, degrading the quality of the frit seal. This is particularly a problem at the corner portions. The invention avoids the problem by providing a frit seal having a substantially identical effective width of sealing all along the frit seal, including both the corner portions and the straight-line portions. Several embodiments are described for obtaining such a frit seal with a substantially identical effective width. In all of the embodiments the amount of radiation energy of the laser must be controlled. This can be done by controlling the intensity or the sweeping speed of the laser. When the sweeping speed is kept constant in the process, the intensity of the laser is reduced as the laser approaches to the corner portion. When the intensity of the laser is kept constant in the process, the sweeping speed of the laser can be increased as the laser approaches the corner portion. Alternatively, the corner portions may be rounded to allow the laser to sweep through the corners without changing energy or speed.

Hereinafter, embodiments according to the present invention will be described with reference to the accompanying drawings. Here, when one element is connected to another element, one element may be not only directly connected to another element but also indirectly connected to another element via another element. Further, irrelative elements are omitted for clarity. Also, like reference numerals refer to like elements throughout.

A large amount of air bubbles may be formed in a surface of the inorganic sealing agent if the capacity of the laser, with which the inorganic sealing agent is irradiated, exceeds a certain capacity value.

In particular, a linear velocity is changed in a curve portion in the operation of equipments, compared to a straight-line portion in the case of a corner portion in which a line type of the inorganic sealing agent is bend, or capacity of the irradiated laser is increased in the curve portion, compared to the straight-line portion even if the inorganic sealing agent is cured at a constant linear velocity. As a result, the corner portion of the inorganic sealing agent is irradiated with a hyperenergy of the laser, and therefore the poor attachment may be made due to the generation of the air bubbles.

An organic light emitting display (OLED) is a display device comprising composed of an array of organic light emitting diodes. Organic light emitting diodes are solid state semiconductor devices which include an organic semiconductive material and are adapted to generate and emit light when appropriate electrical potentials are applied.

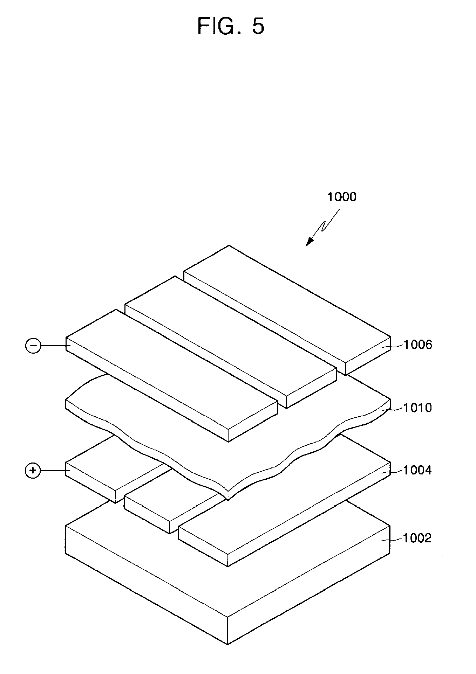

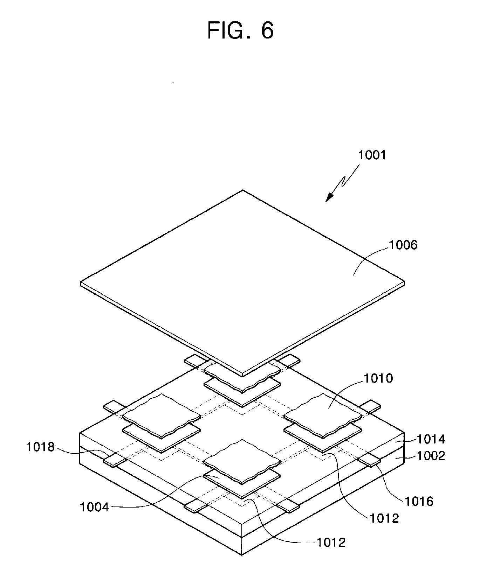

OLEDs can be generally grouped into two basic types dependent on the arrangement with which the stimulating electrical current is provided. Fig. 5 schematically illustrates an exploded view of a simplified structure of a passive matrix type OLED 1000. Fig. 6 schematically illustrates a simplified structure of an active matrix type OLED 1001. In both configurations, the OLED 1000, 1001 includes OLED pixels built over a substrate 1002, and the OLED pixels include an anode 1004, a cathode 1006 and an organic layer 1010. When an appropriate electrical current potential is applied to between the anode 1004 and cathode 1006, electric current flows through the pixels and visible light is emitted from the organic layer.

Referring to Fig. 5, the passive matrix OLED (PMOLED) design includes elongate strips of anode 1004 arranged generally perpendicular to elongate strips of cathode 1006 with organic layers interposed therebetween. The intersections of the strips of cathode 1006 and anode 1004 define individual OLED pixels where light is generated and emitted upon appropriate excitation of the corresponding strips of anode 1004 and cathode 1006. PMOLEDs provide the advantage of relatively simple fabrication. PMOLEDs are often preferred in applications wherein a display size is relatively small to thereby control electrical losses along the elongate strips of anode 1004 and cathode 1006.

Referring to Fig. 6, the active matrix OLED (AMOLED) includes local switching driving circuits 1012 arranged between the substrate 1002 and an array of OLED pixels. An individual pixel of AMOLEDs is defined between the common cathode 1006 and an anode 1004, which is electrically isolated from other anodes. Each local switching circuitdriving circuit 1012 is coupled engaged with an anode 1004 of the OLED pixels and further coupled engaged with a data line 1016 and a scan line 1018. In embodiments, the scan lines 1018 supply select scan signals that select rows of the switching circuitdriving circuits, and the data lines 1016 supply data signals for particular switching circuitdriving circuits in synchronization with the scan signals. The data signals and scan signals stimulate the local switching circuitdriving circuits 1012, which excite the anodes 1004 so as to emit light from their corresponding pixels.

In the illustrated AMOLED, the local switching circuitdriving circuits 1012, the data lines 1016 and scan lines 1018 are buried in a planarization layer 1014, which is interposed between the pixel array and the substrate 1002. The planarization layer 1014 provides a planar top surface on which the organic light emitting pixel array is formed. The planarization layer 1014 may be formed of organic or inorganic materials, and formed of two or more layers although shown as a single layer. The local switching circuitdriving circuits 1012 are typically formed with thin film transistors (TFT) and arranged in a grid or array under the OLED pixel array. The local switching circuitdriving circuits 1012 may be at least partly made of organic materials, including organic TFT.

AMOLEDs have the advantage of fast response timerefresh rates improving their desirability for use in displaying video data signals. Also, AMOLEDs have the advantages of consuming less power than passive matrix OLEDs. These can make AMOLED devices preferred in embodiments requiring relatively large displays.

Referring to common features of the PMOLED and AMOLED designs, the substrate 1002 provides structural support for the OLED pixels and circuits. In various embodiments, the substrate 1002 can comprise rigid or flexible materials as well as opaque or transparent materials, such as plastic, glass, and/or foil. As noted above, each OLED pixel or diode is formed with the anode 1004, cathode 1006 and organic layer 1010 interposed therebetween. When an appropriate electrical current potential is applied to between the anode 1004 and cathode 1006, the cathode 1006 injects electrons and the anode 1004 takes up or removes electronsinjects holes. In certain embodiments, the anode 1004 and cathode 1006 are inverted; i.e., the cathode is formed on the substrate 1002 and the anode is opposingly arranged.

Interposed between the cathode 1006 and anode 1004 are one or more organic layers. More specifically, at least one emissive or light emitting layer is interposed between the cathode 1006 and anode 1004. The light emitting layer may comprise one or more light emitting organic compounds. Typically, the light emitting layer is configured to emit visible light in a single color such as blue, green, or red or white. In the illustrated embodiment, one organic layer 1010 is formed between the cathode 1006 and anode 1004 and acts as a light emitting layer. Additional layers, which can be formed between the anode 1004 and cathode 1006, can include a hole transporting layer, a hole injection layer, an electron transporting layer and an electron injection layer.

Hole transporting and/or injection layers can be interposed between the light emitting layer 1010 and the anode 1004. Electron transporting and/or injecting layers can be interposed between the cathode 1006 and the light emitting layer 1010. The electron injection layer facilitates injection of electrons from the cathode 1006 toward the light emitting layer 1010 by reducing the work function for injecting electrons from the cathode 1006. Similarly, the hole injection layer facilitates injection of holes from the anode 1004 toward the light emitting layer 1010. The hole and electron transporting layers facilitate movement of the carriers injected from the respective electrodes toward the light emitting layer.

In some embodiments, a single layer may serve both electron injection and transportation functions or both hole injection and transportation functions. In some embodiments, one or more of these layers are lacking. In some embodiments, one or more organic layers are doped with one or more materials that help injection and/or transportation of the carriers. In embodiments where only one organic layer is formed between the cathode and anode, the organic layer may include not only an organic light emitting compound but also certain functional materials that help injection or transportation of carriers within that layer.

There are numerous organic materials that have been developed for use in these layers including the light emitting layer. Also, numerous other organic materials for use in these layers are being developed. In some embodiments, these organic materials may be macromolecules including oligomers and polymers. In some embodiments, the organic materials for these layers may be relatively small molecules. A person skilled in the art will be able to select appropriate materials for each of these layers in view of the desired functions of the individual layers and the materials for the neighboring layers in particular designs.

In operation, an electrical circuit provides appropriate potential between the cathode 1006 and anode 1004. This results in an electrical current flowing from the anode 1004 to the cathode 1006 via the interposed organic layer(s). In one embodiment, the cathode 1006 provides electrons to the adjacent organic layer 1010. The anode 1004 injects holes to removes electrons from the organic layer 1010 which is comparable to providing holes to the organic layer 1010. The holes and electrons recombine in the organic layer 1010 and generate energy particles called "excitons." The excitons transfer their energy to the organic light emitting material in the organic layer 1010, and the energy is used to emit visible light from the organic light emitting material. The spectral characteristics of light generated and emitted by the OLED 1000, 1001 depend on the nature and composition of organic molecules in the organic layer(s). The composition of the one or more organic layers can be selected to suit the needs of a particular application by one of ordinary skill in the art.

OLED devices can also be categorized based on the direction of the light emission. In one type referred to as "top emission" type, OLED devices emit light and display images through the cathode or top electrode 1006. In these embodiments, the cathode 1006 is made of a material transparent or at least partially transparent with respect to visible light. In certain embodiments, to avoid losing any light that can pass through the anode or bottom electrode 1004, the anode may be made of a material substantially reflective of the visible light. A second type of OLED devices emits light through the anode or bottom electrode 1004 and is called "bottom emission" type. In the bottom emission type OLED devices, the anode 1004 is made of a material which is at least partially transparent with respect to visible light. Often, in bottom emission type OLED devices, the cathode 1006 is made of a material substantially reflective of the visible light. A third type of OLED devices emits light in two directions, e.g. through both anode 1004 and cathode 1006. Depending upon the direction(s) of the light emission, the substrate may be formed of a material which is transparent, opaque or reflective of visible light.

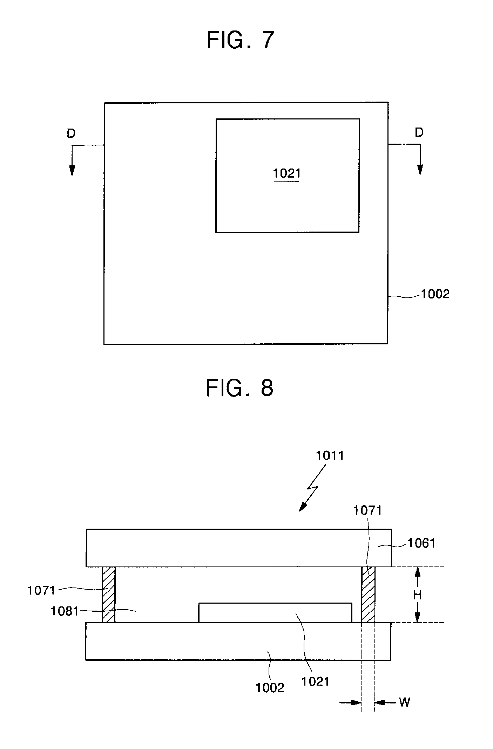

In many embodiments, an OLED pixel array 1021 comprising a plurality of organic light emitting pixels is arranged over a substrate 1002 as shown in Fig. 7. In embodiments, the pixels in the array 1021 are controlled to be turned on and off by a driving circuit (not shown), and the plurality of the pixels as a whole displays information or image on the array 1021. In certain embodiments, the OLED pixel array 1021 is arranged with respect to other components, such as drive and control electronics to define a display region and a non-display region. In these embodiments, the display region refers to the area of the substrate 1002 where OLED pixel array 1021 is formed. The non-display region refers to the remaining areas of the substrate 1002. In embodiments, the non-display region can contain logic and/or power supply circuitry. It will be understood that there will be at least portions of control/drive circuit elements arranged within the display region. For example, in PMOLEDs, conductive components will extend into the display region to provide appropriate potential to the anode and cathodes. In AMOLEDs, local switching circuitdriving circuits and data/scan lines engaged coupled with the switching circuitdriving circuits will extend into the display region to drive and control the individual pixels of the AMOLEDs.

One design and fabrication consideration in OLED devices is that certain organic material layers of OLED devices can suffer damage or accelerated deterioration from exposure to water, oxygen or other harmful gases. Accordingly, it is generally understood that OLED devices be sealed or encapsulated to inhibit exposure to moisture and oxygen or other harmful gases found in a manufacturing or operational environment. Fig. 8 schematically illustrates a cross-section of an encapsulated OLED device 1011 having a layout of Fig. 7 and taken along the line d-d of Fig. 7. In this embodiment, a generally planar top plate or substrate 1061 engages with a seal 1071 which further engages with a bottom plate or substrate 1002 to enclose or encapsulate the OLED pixel array 1021. In other embodiments, one or more layers are formed on the top plate 1061 or bottom plate 1002, and the seal 1071 is engaged coupled with the bottom or top substrate 1002, 1061 via such a layer. In the illustrated embodiment, the seal 1071 extends along the periphery of the OLED pixel array 1021 or the bottom or top plate 1002, 1061.

In embodiments, the seal 1071 is made of a frit material as will be further discussed below. In various embodiments, the top and bottom plates 1061, 1002 comprise materials such as plastics, glass and/or metal foils which can provide a barrier to passage of oxygen and/or water to thereby protect the OLED pixel array 1021 from exposure to these substances. In embodiments, at least one of the top plate 1061 and the bottom plate 1002 are formed of a substantially transparent material.

To lengthen the life time of OLED devices 1011, it is generally desired that seal 1071 and the top and bottom plates 1061, 1002 provide a substantially non-permeable seal to oxygen and water vapor and provide a substantially hermetically enclosed space 1081. In certain applications, it is indicated that the seal 1071 of a frit material in combination with the top and bottom plates 1061, 1002 provide a barrier to oxygen of less than approximately 10⁻³ cc/m²-day and to water of less than 10⁻⁶ g/m²-day. Given that some oxygen and moisture can permeate into the enclosed space 1081, in some embodiments, a material that can take up oxygen and/or moisture is formed within the enclosed space 1081.

The seal 1071 has a width W, which is its thickness in a direction parallel to a surface of the top or bottom substrate 1061, 1002 as shown in Fig. 8. The width varies among embodiments and ranges from about 300 µm to about 3000 µm, optionally from about 500 µm to about 1500 µm. Also, the width may vary at different positions of the seal 1071. In some embodiments, the width of the seal 1071 may be the largest where the seal 1071 contacts one of the bottom and top substrate 1002, 1061 or a layer formed thereon. The width may be the smallest where the seal 1071 contacts the other. The width variation in a single cross-section of the seal 1071 relates to the cross-sectional shape of the seal 1071 and other design parameters.

The seal 1071 has a height H, which is its thickness in a direction perpendicular to a surface of the top or bottom substrate 1061, 1002 as shown in Fig. 8. The height varies among embodiments and ranges from about 2 µm to about 30 µm, optionally from about 10 µm to about 15 µm. Generally, the height does not significantly vary at different positions of the seal 1071. However, in certain embodiments, the height of the seal 1071 may vary at different positions thereof.

In the illustrated embodiment, the seal 1071 has a generally rectangular cross-section. In other embodiments, however, the seal 1071 can have other various cross-sectional shapes such as a generally square cross-section, a generally trapezoidal cross-section, a cross-section with one or more rounded edges, or other configuration as indicated by the needs of a given application. To improve hermeticity, it is generally desired to increase the interfacial area where the seal 1071 directly contacts the bottom or top substrate 1002, 1061 or a layer formed thereon. In some embodiments, the shape of the seal can be designed such that the interfacial area can be increased.

The seal 1071 can be arranged immediately adjacent the OLED array 1021, and in other embodiments, the seal 1071 is spaced some distance from the OLED array 1021. In certain embodiment, the seal 1071 comprises generally linear segments that are connected together to surround the OLED array 1021. Such linear segments of the seal 1071 can extend, in certain embodiments, generally parallel to respective boundaries of the OLED array 1021. In other embodiment, one or more of the linear segments of the seal 1071 are arranged in a non-parallel relationship with respective boundaries of the OLED array 1021. In yet other embodiments, at least part of the seal 1071 extends between the top plate 1061 and bottom plate 1002 in a curvilinear manner.

As noted above, in certain embodiments, the seal 1071 is formed using a frit material or simply "frit" or glass frit," which includes fine glass particles. The frit particles includes one or more of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate, etc. In embodiments, these particles range in size from about 2 µm to about 30 µm, optionally about 5 µm to about 10 µm, although not limited only thereto. The particles can be as large as about the distance between the top and bottom substrates 1061, 1002 or any layers formed on these substrates where the frit seal 1071 contacts.

The frit material used to form the seal 1071 can also include one or more filler or additive materials. The filler or additive materials can be provided to adjust an overall thermal expansion characteristic of the seal 1071 and/or to adjust the absorption characteristics of the seal 1071 for selected frequencies of incident radiant energy. The filler or additive material(s) can also include inversion and/or additive fillers to adjust a coefficient of thermal expansion of the frit. For example, the filler or additive materials can include transition metals, such as chromium (Cr), iron (Fe), manganese (Mn), cobalt (Co), copper (Cu), and/or vanadium. Additional materials for the filler or additives include ZnSiO₄, PbTiO₃, ZrO₂ eucryptite.

In embodiments, a frit material as a dry composition contains glass particles from about 20 to 90 about wt%, and the remaining includes fillers and/or additives. In some embodiments, the frit paste contains about 10-30 wt% organic materials and about 70-90% inorganic materials. In some embodiments, the frit paste contains about 20 wt% organic materials and about 80 wt% inorganic materials. In some embodiments, the organic materials may include about 0-30 wt% binder(s) and about 70-100 wt% solvent(s). In some embodiments, about 10 wt% is binder(s) and about 90 wt% is solvent(s) among the organic materials. In some embodiments, the inorganic materials may include about 0-10 wt% additives, about 20-40 wt% fillers and about 50-80 wt% glass powder. In some embodiments, about 0-5 wt% is additive(s), about 25-30 wt% is filler(s) and about 65-75 wt% is the glass powder among the inorganic materials.

In forming a frit seal, a liquid material is added to the dry frit material to form a frit paste. Any organic or inorganic solvent with or without additives can be used as the liquid material. In embodiments, the solvent includes one or more organic compounds. For example, applicable organic compounds are ethyl cellulose, nitro cellulose, hydroxyl propyl cellulose, butyl carbitol acetate, terpineol, butyl cellusolve, acrylate compounds. Then, the thus formed frit paste can be applied to form a shape of the seal 1071 on the top and/or bottom plate 1061, 1002.

In one exemplary embodiment, a shape of the seal 1071 is initially formed from the frit paste and interposed between the top plate 1061 and the bottom plate 1002. The seal 1071 can in certain embodiments be pre-cured or pre-sintered to one of the top plate and bottom plate 1061, 1002. Following assembly of the top plate 1061 and the bottom plate 1002 with the seal 1071 interposed therebetween, portions of the seal 1071 are selectively heated such that the frit material forming the seal 1071 at least partially melts. The seal 1071 is then allowed to resolidify to form a secure joint between the top plate 1061 and the bottom plate 1002 to thereby inhibit exposure of the enclosed OLED pixel array 1021 to oxygen or water.

In embodiments, the selective heating of the frit seal is carried out by irradiation of light, such as a laser or directed infrared lamp. As previously noted, the frit material forming the seal 1071 can be combined with one or more additives or filler such as species selected for improved absorption of the irradiated light to facilitate heating and melting of the frit material to form the seal 1071.

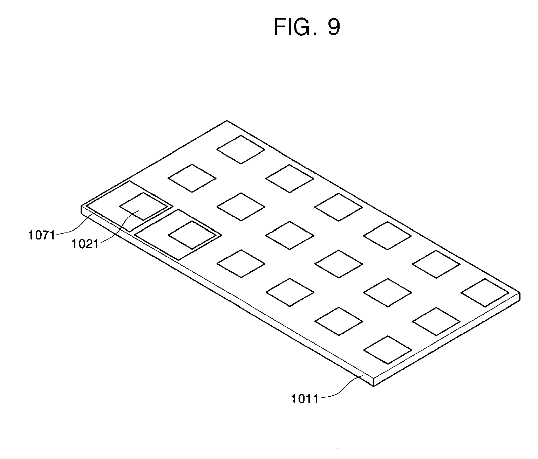

In some embodiments, OLED devices 1011 are mass produced. In an embodiment illustrated in Fig. 9, a plurality of separate OLED arrays 1021 is formed on a common bottom substrate 1101. In the illustrated embodiment, each OLED array 1021 is surrounded by a shaped frit to form the seal 1071. In embodiments, common top substrate (not shown) is placed over the common bottom substrate 1101 and the structures formed thereon such that the OLED arrays 1021 and the shaped frit paste are interposed between the common bottom substrate 1101 and the common top substrate. The OLED arrays 1021 are encapsulated and sealed, such as via the previously described enclosure process for a single OLED display device. The resulting product includes a plurality of OLED devices kept together by the common bottom and top substrates. Then, the resulting product is cut into a plurality of pieces, each of which constitutes an OLED device 1011 of Fig. 8. In certain embodiments, the individual OLED devices 1011 the Fig. 6 further undergo additional packaging operations to further improve the sealing formed by the frit seal 1071 and the top and bottom substrates 1061, 1002.

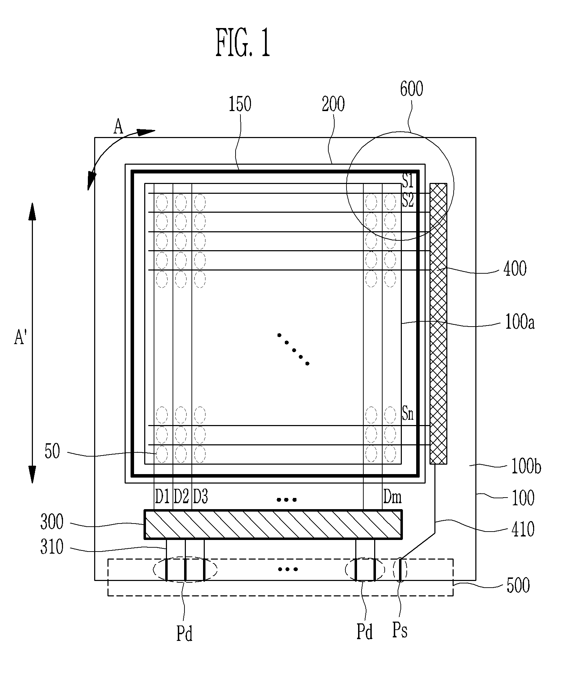

FIG. 1 is a plane schematic view showing an organic light emitting display device according to an embodiment of the present invention.

Referring to FIG. 1, the organic light emitting display device includes a first substrate 100, an inorganic sealing agent 150 and a second substrate 200.

The first substrate 100 includes a pixel array 100a having at least one organic light emitting diode formed therein. The pixel array 100a includes a plurality of scan lines (S1,S2,...Sn) and a plurality of data lines (D1,D2,...Dm), and also includes a plurality of pixels 50 in a region defined by the scan lines (S1,S2,...Sn) and the data lines (D1,D2,...Dm). At this time, each of the pixels 50 is electrically connected to the certain scan lines (S1,S2,...Sn), the certain data lines (D1,D2,...Dm) and a power line (not shown), and displays one of red, green, blue and white colors at a predetermined luminance level.

The data driver 300 supplies a data signal to a plurality of the data lines (D1,D2,...Dm) which are extended in the pixel array 100a of the first substrate 100. The data driver 300 is installed in one side of a circumference 100b of the pixel array 100a in a chip form of a COG (Chip On Glass) type. Also, the data driver 300 is electrically connected to a plurality of first pads (Pd) in a pad unit 500 by means of a plurality of data supply lines 310.

The scan driver 400 sequentially supplies a scan signal to a plurality of the scan lines (S1,S2,...Sn) which are extended in the pixel array 100a. The scan driver 400 is formed in one side of the pixel array 100a in the first substrate 100, and electrically connected to at least a first pad (Ps) in the pad unit 500 by means of at least one scan supply line 410.

The pad unit 500 is formed in the first substrate 100 adjacent to the scan driver 400 and the data driver 300, and electrically connected to the scan supply lines 410 and the data supply lines 310 to supply an electrical signal to a plurality of the scan lines (S1,S2,..Sn) and a plurality of the data lines (D1,D2,...Dm) of the pixel array 100a, respectively.

The inorganic sealing agent 150 is disposed between the circumference 100b of the pixel array 100a and the second substrate 200, and attaches the first substrate 100 to the second substrate 200. The inorganic sealing agent 150 may be applied to seal the pixel array 100a formed in the first substrate 100, as shown in FIG. 1, and may be applied to seal the pixel array 100a and the scan driver 400 if the scan driver 400 is disposed inside. For example, the inorganic sealing agent may be one frit selected from the group consisting of plumber oxide, titanium oxide, vanadium oxide, aluminum oxide and silicon oxide.

That is to say, the organic light emitting diode interposed between the first substrate 100 and the second substrate 200 may be protected from moisture or oxygen since a space between the first substrate 100 and the second substrate 200 is sealed by the inorganic sealing agent 150. At this time, the inorganic sealing agent 150 includes a filler (not shown) for controlling a thermal expansion coefficient; and an absorbing agent (not shown) for absorbing a laser. Also, the inorganic sealing agent 150 is melted by means of the heat such as a laser, etc.

Meanwhile, the inorganic sealing agent 150 has a straight-line portion (A) and a corner portion (A'). Here, the straight-line portion (A) represents a region that is formed parallel to four sides of the pixel region 100a in a region of the inorganic sealing agent 150, and the corner portion (A') represents a region that is bended to correspond to a corner portion of the pixel region 100a in a region of the inorganic sealing agent 150. At this time, air bubbles included in the straight-line portion (A) and the corner portion (A') of the inorganic sealing agent 150 are formed at the same concentration. That is to say, a large amount of air bubbles are generated since the corner portion (A') of the inorganic sealing agent 150 is irradiated with a hyperenergy of the laser if the inorganic sealing agent 150 is not irradiated with the laser at a constant energy capacity. Therefore, the adhesive property of the substrates (100,200) by the inorganic sealing agent 150 is deteriorated since a width of the corner portion (A') gets wider than that of the straight-line portion (A). Accordingly, intensity or rate of a laser beam should be controlled so that a constant energy capacity can be applied to the straight-line portion (A) and the corner portion (A') of the inorganic sealing agent 150. This context will be described in more detail later.

Meanwhile, the inorganic sealing agent 150 may be a frit. A glass powdery form of frit is formed if a temperature of the heat applied to the glass material suddenly falls down. Generally, the frit including oxide powder with the glass powder is used in the art. And, the frit becomes a paste of the gel state when an organic material is added to the frit. Then, if the paste of the gel state is sintered at a predetermined temperature, then the organic material is evaporated into the air, and the paste of gel state is cured andbecomes a frit of solid state.

The second substrate 200 is coalesced to one region including the pixel array 100a of the first substrate 100. At this time, the second substrate 200 is provided so that the organic light emitting diode (not shown), formed in the pixel array 100a of the first substrate 100, can be protected from being affected by moisture or oxygen from the outside.

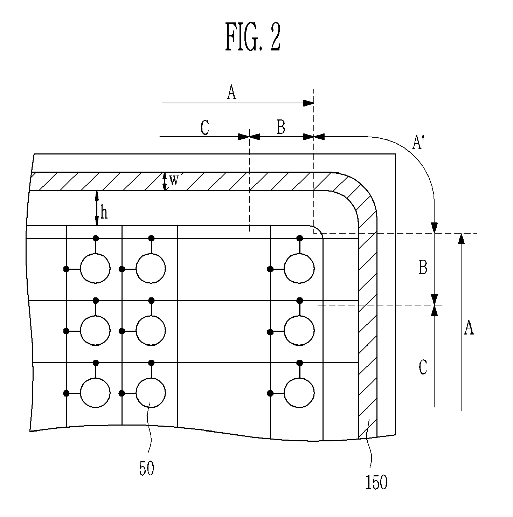

FIG. 2 is an exploded view showing one region of FIG. 1.

Referring to FIG. 2, it is revealed that a width (w) of the inorganic sealing agent 150 is uniformly formed since the air bubbles included in the straight-line portion (A) and the corner portion (A') of the inorganic sealing agent 150 are controlled at the same concentration, as described above with reference to FIG. 1. Also, effective sealing widths of the straight-line portion (A) and the corner portion (A') are formed at the same width. At this time, a ratio of the effective sealing width between the straight-line portion and the corner portion may range from 0.85 to 1 of the total sealing width. Here, the effective sealing width represents a width in which the first substrate 100 and the second substrate 200 are actually sealed by the laser irradiation.

And, the total width (W) including the effective sealing width of the inorganic sealing agent 150 may be varied depending on design standards of small-sized panels such as mobile phones, and may range from 0.6 to 1 mm in consideration of a dead space in the generally used panels. However, the total width (W) may be 1 mm or more for the purpose of ensuring suitable attachment if the panels are increased in their size and there is no limit to external design rules.

Meanwhile, the corner portion (A') may be formed with a curvature of 0.5 to 1.5 mm, or also formed perpendicularly. Here, the inorganic sealing agent 150 is formed with a thickness of 5 to 30 um, and this thickness, which is suitable for effectively carrying out the melting and attaching processes using a laser, is also a height formed in a common printing process.

Also, vertical distances from the outer wall of the pixel array 100a to the straight-line portion (A) and the corner portion (A') are identical to each other.

At this time, the conditions as described above may be satisfied by controlling an intensity of a laser beam irradiated with the inorganic sealing agent 150 or a moving rate of a head (not shown) of the laser irradiation equipment to apply the same capacity of energy to the straight-line portion (A) and the corner portion (A') of the inorganic sealing agent 150.

Meanwhile, the straight-line portion (A) is divided into a plurality of regions and irradiated with the laser at lower intensity or more rapid rate as the straight-line portion (A) approaches the corner portion (A'). That is to say, the inorganic sealing agent 150 may be formed with a constant width over the entire region by gradually controlling intensity of a laser beam for the purpose of uniformity of the energy capacity. For example, the straight-line portion (A) may be divided into two regions to control the laser beam. That is to say, a first straight-line portion (B), which is relatively closer to the corner portion (A') out of two regions of the straight-line portion (A), is irradiated with the laser having an intensity of 12.5 W, and a second straight-line portion (C), which is relatively remoter from the corner portion (A'), is irradiated with the laser having an intensity of 13.5 W. And, the inorganic sealing agent 150 is homogeneously formed over the entire region by irradiating the corner portion (A') with the laser having an intensity of 11 W. At this time, a constant energy capacity may be applied over the entire region of the inorganic sealing agent 150 by lowering a laser intensity as a head of a laser irradiation equipment (not shown) approaches the corner portion (A') as the head of the laser irradiation equipment (not shown) moves more slowly in the corner portion (A').

One embodiment in which the intensity of the laser is controlled depending on the regions of the inorganic sealing agent 150 is described in the above, but the inorganic sealing agent 150 may be homogeneously formed by controlling a moving rate of the head of the laser irradiation equipment and maintaining a constant intensity of the laser over the entire region. That is to say, energy capacities applied to the corner portion (A') and the straight-line portion (A) are made identical by controlling the moving rate of the head of the laser irradiation equipment so that the head of the laser irradiation equipment can move more swiftly as it approaches the corner portion (A') of the inorganic sealing agent 150. At this time, the intensity of the lasers, which are irradiated to the corner portion (A') and the straight-line portion (A) is same.

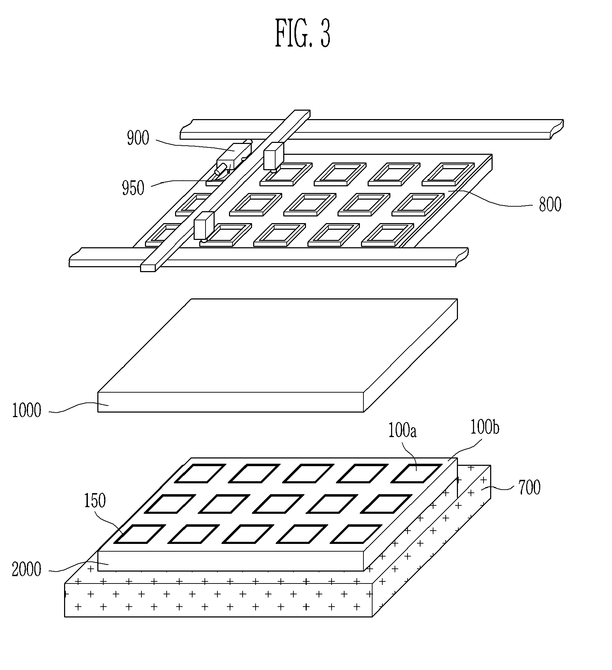

FIG. 3 is a perspective view showing the organic light emitting display device according to another embodiment of the present invention and a laser irradiation equipment for fabricating the same.

Referring to FIG. 3, the organic light emitting display device includes a first mother substrate 1000, a frit 150 and a second mother substrate 2000, and the laser irradiation equipment includes a substrate stage 700, a mask 800, a monitor sensor 900 and a laser head 950.

The organic light emitting display device is not described herein since it is the same as described with reference to FIG. 1.

The substrate stage 700 supports the first mother substrate 1000 and the second mother substrate 2000 for the purpose of carrying out a coalescence process between the first mother substrate 1000 and the second mother substrate 2000. For example, the second substrate 2000 in which the inorganic sealing agent 150 is formed is first arranged on the substrate stage 700. Then, the first mother substrate 1000 having at least one organic light emitting diode in one region thereof is arranged in an opposing region of the second mother substrate 2000. And then, a load is given onto the first mother substrate 1000 to coalesce the first mother substrate 1000 and the second mother substrate 2000, and then the subsequent processes are carried out.

Only the inorganic sealing agent 150 may be selectively irradiated with the heats such as a laser, etc. without damage to the pixel array 100a by the heat by employing a mask 800.

The monitor sensor 900 senses a position of the inorganic sealing agent 150 interposed between the first mother substrate 1000 and the second mother substrate 2000, thereby to allow a region, in which the inorganic sealing agent 150 is arranged, to be exactly irradiated with a laser beam.

The laser head 950 is connected with the monitor sensor 900, and angle and width of the laser beam may be changed depending on the shape of the laser head 950. Meanwhile, the inorganic sealing agent 150 may be homogeneously formed over the entire region in an embodiment of the present invention by controlling a moving rate of the laser head 950 that moves along the inorganic sealing agent 150, or by controlling an intensity of the laser beam applied to the inorganic sealing agent 150 through the laser head 950.

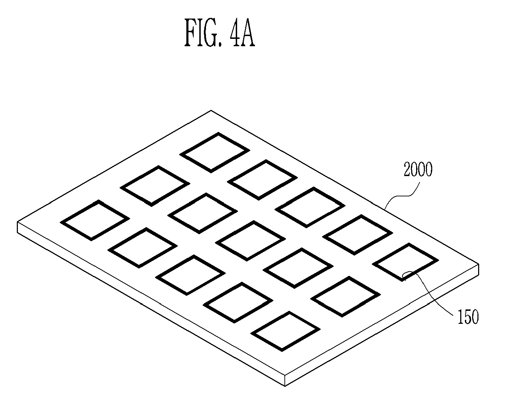

FIG. 4a to FIG. 4d are a perspective view showing a sheet unit of the organic light emitting display device and a fabricating method of the same according to still another embodiment of the present invention.

Referring to FIG. 4a to FIG. 4d, the organic light emitting display device includes a first mother substrate 1000 including at least one pixel array 100a having an organic light emitting diode formed therein; and a second mother substrate 2000 coalesced to the first mother substrate 1000.

The method for fabricating an organic light emitting display device using the above-mentioned components is firstly carried out by applying the inorganic sealing agent 150 to a region surrounding a circumference 100b of the pixel array 100a on the second mother substrate 2000, followed by sintering the inorganic sealing agent 150 at a predetermined temperature. Here, the process for sintering the inorganic sealing agent 150 may be carried out at a range of 300 °C to 700 °C in a furnace. Organic materials are not easily evaporated in the sintering process if the sintering temperature of the inorganic sealing agent 150 is less than 300 °C. And, if the sintering temperature exceeds 700 °C, then intensity of the laser beam should be proportionately increased to correspond to the increase in the sintering temperature, and therefore it is undesirable to increase the sintering temperature to 700 °C or above. At this time, the inorganic sealing agent 150 includes a filler (not shown) for controlling a thermal expansion coefficient and an absorbing agent (not shown) for absorbing a laser or infrared rays (FIG. 4a).

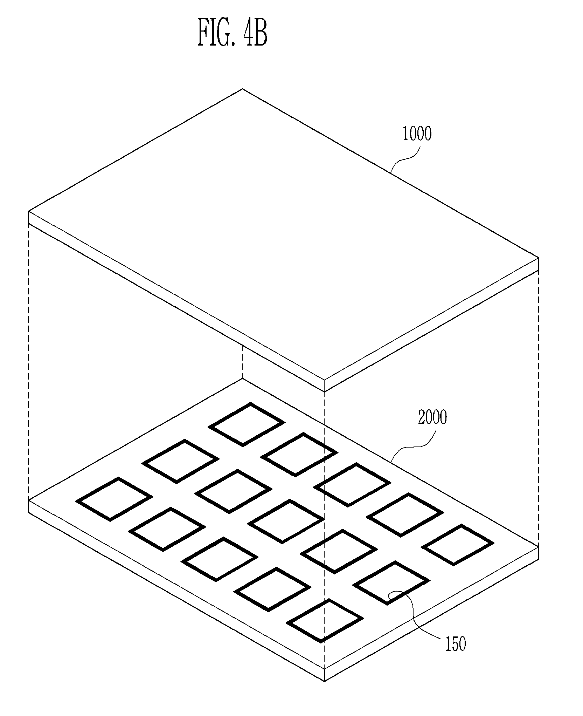

And then, the first mother substrate 1000 and the second mother substrate 2000 are coalesced to each other. At this time, at least one organic light emitting diode (not shown) including a first electrode, an organic layer and a second electrode is formed in the first mother substrate 1000, and the organic light emitting diode is arranged to be positioned between the first mother substrate 1000 and the second mother substrate 2000, and then the first mother substrate 1000 and the second mother substrate 2000 are coalesced to each other (FIG. 4b).

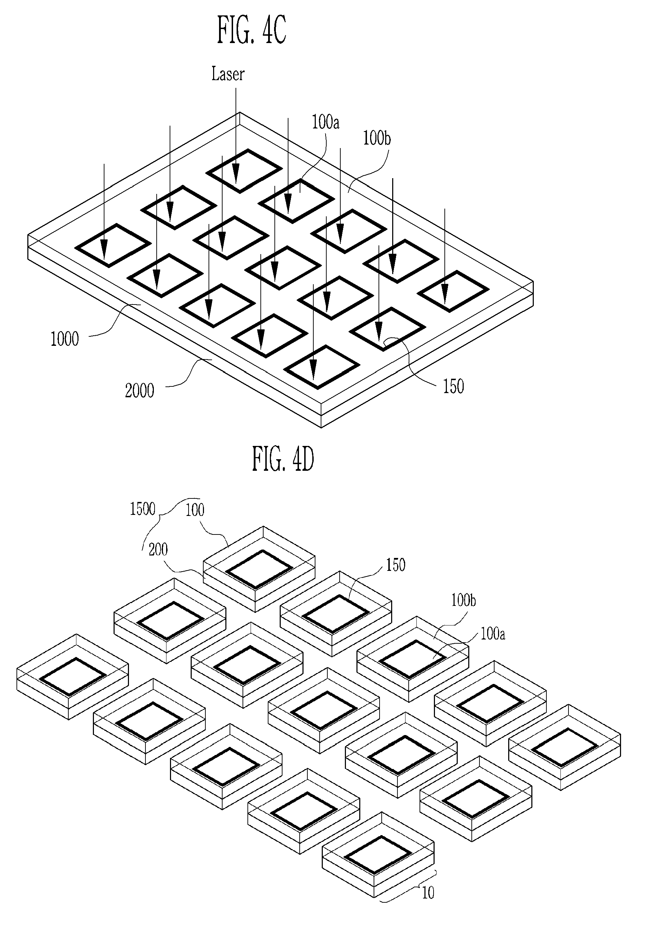

As a subsequent process, the inorganic sealing agent 150 is melted by irradiating the inorganic sealing agent 150 with a laser and then it is cured. That is to say, the first mother substrate 1000 and the second mother substrate 2000 are attached to each other when the inorganic sealing agent 150 is melted. At this time, the process for irradiating the inorganic sealing agent 150 with a laser is not described herein since the irradiation method is the same as described with reference to FIG. 1 to FIG. 3 (FIG. 4c).

And then, the coalesced first mother substrate 1000 and second mother substrate 2000 are cut into a plurality of display panels 1500 (FIG. 4d).

The organic light emitting display device and the fabricating method of the same according to embodiments of the present invention may be useful to prevent a large amount of air bubbles from being generated in the corner portion due to a hyperenergy of the irradiated laser by controlling the laser so that the laser is applied at the same energy capacity over the inorganic sealing agent, and therefore the adhesive property between the substrates by the inorganic sealing agent may be improved.

## Claims

1. An organic light emitting display device comprising:
a first substrate;
a second substrate;
an array of organic light emitting pixels, the array being interposed between the first substrate and the second substrate; and
a frit seal interconnecting the first substrate and the second substrate, the frit seal comprising a plurality of straight-line portions and a plurality of corner portions, each of the portions comprising sealing surfaces to each of the first and second substrates,
wherein a first width of the sealing surface of a first straight-line portion of the plurality of straight-line portions and a second width of the sealing surface of a first corner portion of the plurality of corner portions, the first corner portion contacting the first straight-line portion, are substantially the same, and wherein the frit seal is substantially homogeneous in width and microstructure in the first straight-line portion and the first corner portion.

2. The device of claim 1, wherein the first corner portion is a rounded corner portion.

3. The device of claim 2, wherein the radius of osculating circle of the rounded corner portion is from about 0.5mm to about 1.5mm.

4. The device of claim 1, wherein the first corner portion comprises a an angle between the first straight-line portion and a second adjacent straight-line portion.

5. The device of one of the preceding claims, wherein the ratio of the first width of the sealing surfaces of the first straight-line portion to the second width of the sealing surfaces of the first corner portion is from about 0.85 to about 1.0.

6. The device of one of the preceding claims, wherein the first width of the sealing surface and the second width of the sealing surface is from about 0.3mm to about 1.0mm.

7. The device of one of the preceding claims, wherein a first thickness of the frit seal of the first straight-line portion is substantially identical to a second thickness of the frit seal of the first corner portion.

8. The device of claim 7, wherein the thickness of the frit seal is from 5µm to about 30µm.

9. The device of one of the preceding claims, wherein the microstructure of the frit seal comprises a plurality of air bubbles trapped in the frit seal.

10. The device of claim 9, wherein the first straight-line portion and the first corner portion contain air bubbles of a substantially identical concentration.

11. A method of fabricating an organic light emitting display device according to one of the preceding claims, the method comprising:
forming a frit material on at least one of the first and second substrates such that the array of organic light emitting pixels is interposed between the first and second substrates; and
applying a laser onto the frit material, whereby the frit seal having a substantially constant width is formed.

12. The method of claim 11, wherein the step of applying the laser is configured for the first straight-line portion and the first corner portion of the frit seal to receive substantially identical amount of energy from the laser.

13. The method of one of claims 11 or 12, wherein applying the laser comprises:
sweeping the laser with a constant speed; and
controlling intensity of the laser according to location that is irradiated by the laser,
wherein the laser is applied to the first corner portion of the frit seal with a reduced intensity.

14. The method of one of the claims 11 through 13, wherein the first straight-line portion comprises a first distant sub-portion located distantly from the first corner portion and a first near sub-portion located closer to the first corner portion, and wherein the laser is applied to the first near sub-portion with lower intensity than to the first distant sub-portion.

15. The method of one of the claims 11 or 12, wherein applying the laser comprises:
maintaining intensity of the laser at a substantially constant value; and
controlling sweeping speed of the laser according to location that is irradiated by the laser,
wherein the laser is applied to the first corner portion of the frit seal with a heightened sweeping speed.

16. The method of Claim 15, wherein the first straight-line portion comprises a second distant sub-portion located distantly from the first corner portion and a second near sub-portion located closer to the first corner portion, and wherein the laser is applied to the second near sub-portion with a higher sweeping speed than to the second distant sub-portion.

17. The method of one of claims 11 through 16, wherein the step of applying a frit material comprises:
providing the second substrate;
applying the frit material on the second substrate;
sintering the frit material at a predetermined temperature;
providing the first substrate and the array of organic light emitting pixels formed on the first substrate; and
coalescing the first substrate to the second substrate such that said array is interposed between the first and second substrates.

18. The method of claim 17, wherein the predetermined temperature is from about 300 °C to about 700 °C.

19. The method of one of claims 17 or 18, further comprising masking the array of organic light emitting pixels such that the array of organic light emitting pixels are not damaged by the laser.

20. The method of claim 11, wherein applying the laser is performed such that the straight-line portions and the corner portions receive a substantially identical amount of energy from the laser.
